# FASCICULE DE BREVET EUROPEEN

(11) **EP 3 080 914 B1**
(45) Date de publication et mention de la délivrance du brevet: **28.10.2020**
(21) Numéro de dépôt: 14825365.1
(22) Date de dépôt: 12.12.2014
(51) Int. Cl.: H03K 17/96

(54) **DETECTEUR DE PROXIMITE**
NÄHERUNGSDETEKTOR
DETECTEUR DE PROXIMITE

(30) Priorité: 13.12.2013 FR 1302933
(43) Date de publication de la demande: 19.10.2016
(73) Titulaire: Valeo Systemes Thermiques, 78320 Le Mesnil Saint Denis (FR)
(72) Inventeur: HYUNH Tan Duc, 93330 Neuilly sur Marne (FR)
(74) Mandataire: Delplanque, Arnaud
(86) Numéro de dépôt international: PCT/FR2014/000278
(87) Numéro de publication internationale: WO 2015/086926

(56) Documents cités:
- EP-A1- 0 688 102
- EP-A1- 2 209 212
- EP-A2- 2 251 762
- WO-A1-2013/098035
- FR-A1- 2 704 332
- FR-A1- 2 944 351
- GB-A- 2 352 297
- US-A1- 2006 289 286
- US-A1- 2007 103 451
- US-A1- 2011 041 409

## Description

### DOMAINE TECHNIQUE DE L'INVENTION

Le domaine technique de l'invention est celui des interfaces homme-machine (IHM). La présente invention concerne un détecteur de proximité, et en particulier un détecteur de proximité d'un équipement de véhicule automobile.

### ARRIERE-PLAN TECHNOLOGIQUE DE L'INVENTION

Une interface homme-machine (IHM) désigne un outil permettant à un utilisateur humain de communiquer avec une machine et de la contrôler. Les interfaces homme-machine peuvent par exemple être de type :
- écran, par exemple un écran LCD à cristaux liquides de type TFT (de l'anglais « Thin-film transistor ») ;
- bouton de commande ;
- système d'éclairage, comme par exemple un plafonnier ;
- levier, par exemple un levier de vitesse.
Afin de permettre et/ou faciliter l'utilisation de telles interfaces, il est connu de leur associer un détecteur de proximité. Un détecteur de proximité peut notamment contrôler :
- le réveil de l'interface IHM ;
- l'affichage d'informations sur l'interface IHM dans le cas où l'interface IHM est un écran ;
- l'éclairage ou le rétro-éclairage de l'interface IHM.
Le détecteur de proximité comporte typiquement une antenne de détection et un circuit imprimé qui sont électriquement connectés. L'antenne de détection est placée derrière un élément de surface d'une interface homme-machine. L'élément de surface est la partie de l'interface qui est la plus proche de l'utilisateur humain : c'est par exemple une façade de télécommande dans le cas d'un bouton de commande, ou un pommeau de levier de vitesse dans le cas d'un levier de vitesse. L'antenne de détection peut par exemple être un film capacitif fixé sous l'élément de surface. Il est connu de connecter électriquement l'antenne de détection et le circuit imprimé au moyen d'un connecteur souple, tel qu'un câble en nappe. Cette solution de connexion électrique peut néanmoins se révéler contraignante et onéreuse. On connaît aussi du document FR2 944 351 une connexion électrique par une tige entre l'antenne et le circuit imprimé. Le document EP0 688 102 divulgue un détecteur de proximité selon l'état de la technique.

### RESUME DE L'INVENTION

L'invention offre une solution aux problèmes évoqués précédemment, en proposant une connexion électrique simple permettant notamment de diminuer le coût de fabrication d'un détecteur de proximité, et notamment d'un détecteur de proximité d'un équipement de véhicule automobile.

L'invention concerne donc, un détecteur de proximité d'un équipement de véhicule automobile selon la revendication 1.

Dans la présente description, on emploie le terme « tige » sans préjuger d'un type particulier de section pour ladite tige. La tige conductrice pourra donc par exemple être de section circulaire, carrée ou rectangulaire.
Grâce à l'invention, la connexion électrique entre l'antenne de détection et le circuit imprimé est assurée avec la tige conductrice, qui est un élément simple et peu onéreux, en particulier par rapport à un connecteur de type câble ruban. Outre les caractéristiques qui viennent d'être évoquées dans le paragraphe précédent, le détecteur de proximité selon un aspect de l'invention peut présenter une ou plusieurs caractéristiques complémentaires parmi les suivantes, considérées individuellement ou selon toutes les combinaisons techniquement possibles :
- La tige conductrice est flexible et présente une capacité de rappel.
- Alternativement, la tige conductrice est rigide.
- Le détecteur de proximité comporte avantageusement un ressort conducteur entourant la tige conductrice, le ressort conducteur présentant une première extrémité et une deuxième extrémité opposée à la première extrémité, la première extrémité étant au contact de l'antenne de détection et la deuxième extrémité étant au contact du circuit imprimé.
- La tige conductrice présente une première extrémité et une deuxième extrémité opposée à la première extrémité, et la première extrémité de la tige conductrice est en contact avec l'antenne de détection et la deuxième extrémité de la tige conductrice est en contact avec le circuit imprimé.
- Alternativement, la tige conductrice présente une partie centrale s'étendant entre une première extrémité et une deuxième extrémité, et :
   ∘ la première extrémité de la tige conductrice est en contact avec l'antenne de détection ;
   ∘ la tige conductrice traverse le circuit imprimé par une ouverture d'ajustement dudit circuit imprimé.

   La partie centrale de la tige conductrice peut en outre avantageusement être en contact avec l'ouverture d'ajustement du circuit imprimé.
- L'antenne de détection étant située d'un premier côté du circuit imprimé, un élément de maintien de la tige conductrice est situé d'un deuxième côté, opposé au premier côté, du circuit imprimé, l'élément de maintien étant connecté électriquement au circuit imprimé.
- La tige conductrice est soudée au circuit imprimé.
- Le détecteur de proximité comporte au moins un élément de support mécanique de l'antenne de détection, ledit élément de support mécanique présentant une première extrémité en contact avec l'antenne de détection et une deuxième extrémité, opposée à la première extrémité, en contact avec le circuit imprimé.

Outre les caractéristiques qui viennent d'être évoquées dans le paragraphe précédent, l'équipement de véhicule automobile selon un aspect de l'invention peut présenter une ou plusieurs caractéristiques complémentaires parmi les suivantes, considérées individuellement ou selon toutes les combinaisons techniquement possibles :
- L'équipement de véhicule automobile comporte :
   ∘ une pluralité d'antennes de détection, chaque antenne de détection générant un signal de détection lorsqu'un utilisateur est présent à proximité dudit équipement ;
   ∘ au moins un circuit imprimé traitant un signal de détection pour la commande d'une action sur ledit équipement ;
   ∘ une pluralité de tiges conductrices, chaque tige conductrice assurant la connexion électrique entre une desdites antennes de détection et un des circuits imprimés.
- L'équipement de véhicule automobile appartient à la liste suivante :
   ∘ un écran ;
   ∘ un bouton de commande ;
   ∘ un système d'éclairage ;
   ∘ un levier.

L'invention et ses différentes applications seront mieux comprises à la lecture de la description qui suit et à l'examen des figures qui l'accompagnent.

L'objet de l'invention est défini par les revendications en annexe. Toute référence à un "mode de réalisation", un "exemple" ou un "aspect" de l'invention dans cette description n'étant pas couvert par la portée des revendications doit être interprétée comme un exemple pour comprendre l'invention.

### BREVE DESCRIPTION DES FIGURES

Les figures sont présentées à titre indicatif et nullement limitatif de l'invention.
- La figure 1a montre une coupe schématique d'un équipement comportant un détecteur de proximité selon un premier mode de réalisation de l'invention.
- La figure 1b montre une perspective schématique partielle de l'équipement de la figure 1a.
- La figure 2a montre une coupe schématique d'un détecteur de proximité selon un deuxième mode de réalisation de l'invention.
- La figure 2b montre une coupe schématique d'un détecteur de proximité selon un troisième mode de réalisation de l'invention.
- La figure 2c montre une coupe schématique d'un détecteur de proximité selon un quatrième mode de réalisation de l'invention.
- La figure 2d montre une coupe schématique d'un détecteur de proximité selon un cinquième mode de réalisation de l'invention.
- La figure 3 montre une coupe schématique partielle d'un deuxième équipement comportant un détecteur de proximité selon le premier mode de réalisation de l'invention.

### DESCRIPTION DETAILLEE D'AU MOINS UN MODE DE REALISATION DE L'INVENTION

Sauf précision contraire, un même élément apparaissant sur des figures différentes présente une référence unique.

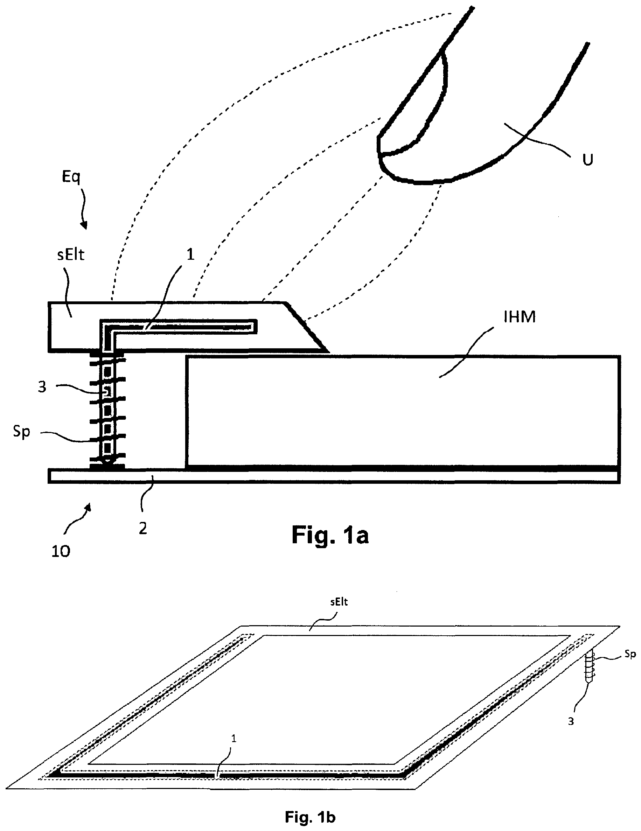

La figure 1a montre une vue en coupe d'un équipement Eq comportant :
- un détecteur de proximité 10 selon un premier mode de réalisation de l'invention, permettant de détecter un utilisateur U ou tout autre type d'objet à proximité de l'équipement Eq ;
- un élément de surface sElt ;
- une interface homme-machine IHM.
L'interface homme-machine IHM peut par exemple être un écran, un bouton de commande, un système d'éclairage ou un levier.

Le détecteur de proximité 10 selon le premier mode de réalisation de l'invention comporte :
- une antenne de détection 1 ;
- un circuit imprimé 2 ;
- une tige conductrice 3 et un ressort conducteur Sp qui connectent électriquement l'antenne de détection 1 avec le circuit imprimé 2. Le ressort conducteur Sp se trouve autour de la tige conductrice 3. Le ressort conducteur Sp est guidé par la tige conductrice 3.
Dans la présente description, le terme « tige » est employé sans préjuger d'un type particulier de section pour ladite tige conductrice 3. La tige conductrice 3 pourra donc par exemple être de section circulaire, carrée ou rectangulaire. L'antenne de détection 1 est avantageusement surmoulée dans l'élément de surface sElt, ce qui lui confère une bonne résistance et une bonne tenue mécanique. La tige conductrice 3 est avantageusement un prolongement de l'antenne de détection 1. Dans ce cas, l'antenne de détection 1 et la tige conductrice 3 forment un ensemble monobloc. Alternativement, la tige conductrice 3 peut être mise en contact avec l'antenne de détection 1 et rendue solidaire de l'antenne de détection 1, par exemple par soudure.
Selon le premier mode de réalisation de l'invention, le ressort conducteur Sp, guidé par la tige conductrice 3, permet avantageusement d'assurer la connexion électrique entre l'antenne de détection 1 et le circuit imprimé 2 tout en permettant une tolérance d'espacement entre l'antenne de détection 1 et le circuit imprimé. Le ressort conducteur Sp présente :
- une première extrémité qui est au contact et solidaire de l'antenne de détection 1 ;
- une deuxième extrémité, opposée à la première extrémité, qui est au contact et solidaire du circuit imprimé 2.
La première extrémité du ressort conducteur Sp est par exemple soudée à l'antenne de détection 1, et la deuxième extrémité du ressort conducteur Sp est par exemple soudée au circuit imprimé 2.
Selon le premier mode de réalisation du détecteur de proximité 10, on distingue deux cas pour l'établissement de la connexion électrique entre l'antenne de détection 1 et le circuit imprimé 2, en fonction de l'espacement entre l'antenne de détection 1 et le circuit imprimé 2 :
- selon un premier cas, l'espacement entre l'antenne de détection 1 et le circuit imprimé 2 correspond à la longueur de la tige conductrice 3 et la tige conductrice 3 est en contact avec le circuit imprimé 2. La connexion électrique entre l'antenne de détection 1 et le circuit imprimé 2 est assurée à la fois par la tige conductrice 3 et par le ressort conducteur Sp.
- Selon un deuxième cas, l'espacement entre l'antenne de détection 1 et le circuit imprimé 2 est supérieur à la longueur de la tige conductrice 3 : la tige conductrice 3 n'est pas en contact avec le circuit imprimé 2. La connexion électrique entre l'antenne de détection et le circuit imprimé 2 est alors assurée par le ressort conducteur Sp.

La figure 1b montre une vue en perspective partielle de l'équipement Eq qui a été précédemment décrit en lien avec la figure 1a. La vue en perspective partielle montre l'élément de surface sElt, l'antenne de détection 1, la tige conductrice 3 et le ressort conducteur Sp. Dans l'exemple particulier représenté à la figure 1b, l'élément de surface sElt est un cadre à quatre côtés. La forme de cadre à quatre côtés de l'élément de surface sElt est particulièrement adaptée au cas où l'interface homme-machine IHM est un écran. L'élément de surface sElt peut présenter un grand nombre de formes différentes, en fonction de la nature et de la géométrie de l'interface homme-machine IHM. Dans l'exemple particulier représenté à la figure 1b, l'antenne de détection 1, surmoulée dans l'élément de surface sElt, s'étend suivant trois côtés de l'élément de surface sElt. L'antenne de détection 1 peut alternativement s'étendre suivant un, deux ou tous les côtés de l'élément de surface sElt. Il est également envisageable que l'antenne de détection 1 s'étende seulement sur une partie d'un côté de l'élément de surface sElt, ou sur une partie de deux côtés consécutifs de l'élément de surface sElt. Plus l'antenne de détection 1 s'étend sur une surface importante, plus la sensibilité de l'antenne de détection1 augmente. Plus les dimensions et l'étendue de l'antenne de détection 1 sont limitées, plus le coût de fabrication du détecteur de proximité 10 est maîtrisé. La tige conductrice 3 et le ressort conducteur Sp sont en contact avec une extrémité de l'antenne de détection 1. Alternativement, la tige conductrice 3 et le ressort conducteur Sp peuvent être en contact avec toute autre partie de l'antenne de détection 1. Selon une première variante du premier mode de réalisation, une pluralité d'antennes de détection 1 peuvent être mises en œuvre, avec par exemple une antenne de détection 1 par côté de l'élément de surface sElt. Selon cette première variante, une pluralité de tiges conductrices 3 et de ressorts conducteurs Sp sont également mis en oeuvre : on utilise une tige conductrice 3 et un ressort conducteur Sp pour chaque antenne de détection. Selon une deuxième variante du premier mode de réalisation, le détecteur de proximité 10 peut comporter au moins un élément de support mécanique de l'antenne de détection 1, ledit élément de support mécanique présentant une première extrémité en contact avec l'antenne de détection 1 et une deuxième extrémité, opposée à la première extrémité, en contact avec le circuit imprimé 2. Le détecteur de proximité 10 peut par exemple comporter une pluralité d'éléments de support mécanique régulièrement répartis le long de l'antenne de détection 1 et placés notamment à des angles de l'antenne de détection 1.

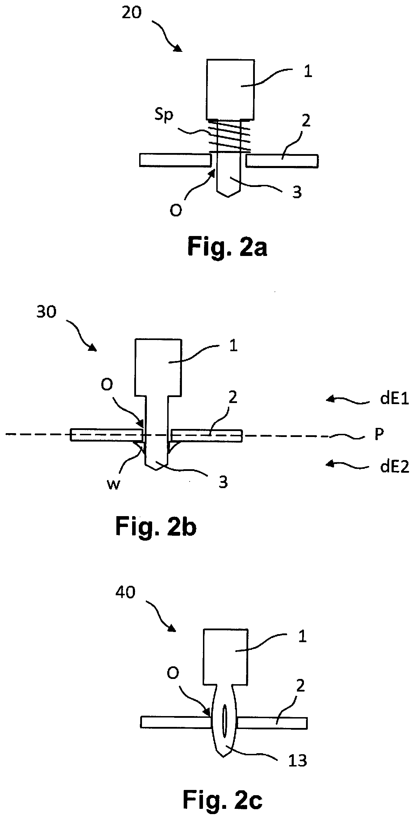

La figure 2a illustre une vue en coupe d'un détecteur de proximité 20 selon un deuxième mode de réalisation de l'invention. Selon le deuxième mode de réalisation de l'invention, le circuit imprimé 2 comporte une ouverture d'ajustement O. Les dimensions de l'ouverture d'ajustement O sont telles que la tige conductrice 3, qui présente une partie centrale s'étendant entre une première extrémité et une deuxième extrémité, peut traverser le circuit imprimé 2 par l'ouverture d'ajustement O. Dans l'exemple illustré à la figure 2a, la tige conductrice 3 n'est pas en contact avec le circuit imprimé 2. La connexion électrique entre l'antenne de détection 1 et le circuit imprimé 2 est donc assurée par le ressort conducteur Sp, qui est guidé par la tige conductrice 3. Alternativement, les dimensions de l'ouverture d'ajustement O peuvent être choisies de manière que, lorsque la tige conductrice 3 traverse l'ouverture d'ajustement O, la partie centrale de la tige conductrice 3 est en contact avec l'ouverture d'ajustement O. Selon cette alternative, lorsque la tige conductrice 3 traverse l'ouverture d'ajustement O, la connexion électrique entre l'antenne de détection 1 et le circuit imprimé 2 est assurée à la fois par la partie centrale 3_c de tige conductrice 3 et par le ressort conducteur Sp.
Le détecteur de proximité 20 selon le deuxième mode de réalisation de l'invention offre avantageusement une tolérance sur l'espacement entre l'antenne de détection 1 et le circuit imprimé 2, la tolérance n'étant pas limitée par la longueur de la tige conductrice 3. En effet :
- si l'espacement entre l'antenne de détection 1 et le circuit imprimé 2 est supérieur ou égal à la longueur de la tige conductrice 3, la tige conductrice 3 ne traverse pas l'ouverture d'ajustement O du circuit imprimé 2 ;
- si en revanche l'espacement entre l'antenne de détection 1 et le circuit imprimé 2 est inférieur à la longueur de la tige conductrice 3, la tige conductrice 3 traverse l'ouverture d'ajustement O du circuit imprimé 2.

La figure 2b illustre une vue en coupe d'un détecteur de proximité 30 selon un troisième mode de réalisation de l'invention. Selon le troisième mode de réalisation, la tige conductrice 3 traverse le circuit imprimé 2 par l'ouverture d'ajustement O du circuit imprimé 2 et la tige conductrice 3 est connectée électriquement au circuit imprimé 2 par un cordon de soudure w. Dans l'exemple représenté à la figure 2b, le circuit imprimé 2 s'étend suivant un plan P définissant un premier demi-espace dE1 et un deuxième demi-espace dE2 ; l'antenne de détection 1 est située dans le premier demi-espace dE1 et le cordon de soudure w est situé dans le deuxième demi-espace dE2. Il est également possible que le cordon de soudure w soit situé dans le premier demi-espace dE1, ou que, selon une alternative non illustrée, la tige conductrice 3 soit connectée électriquement au circuit imprimé 2 par des premier et deuxième cordons de soudure situés de part et d'autre du circuit imprimé 2. Selon le troisième mode de réalisation, on n'utilise pas de ressort, ce qui permet avantageusement de simplifier le détecteur de proximité. Selon une première variante du troisième mode de réalisation, le circuit imprimé 2 peut ne pas comporter d'ouverture d'ajustement. Dans ce cas, la tige conductrice 3 ne traverse pas le circuit imprimé et est connectée électriquement au circuit imprimé 2 par un cordon de soudure, qui est situé dans le premier demi-espace dE1. Selon une deuxième variante du troisième mode de réalisation, on utilise une tige conductrice flexible et présentant une capacité de rappel. La tige conductrice selon la deuxième variante du troisième mode de réalisation peut par exemple être :
- une tige conductrice en forme de « V » ou en forme de « V inversé » ;
- une tige conductrice coudée.
La deuxième variante du troisième mode de réalisation offre avantageusement une tolérance mécanique sur l'espacement entre l'antenne de détection 1 et le circuit imprimé 2 tout en garantissant une connexion électrique entre l'antenne de détection 1 et le circuit imprimé 2 grâce à la tige conductrice, qui peut être plus ou moins comprimée ou allongée. Les première et deuxième variantes du troisième mode de réalisation sont compatibles l'une avec l'autre.

La figure 2c illustre une vue en coupe d'un détecteur de proximité 40 selon un quatrième mode de réalisation de l'invention. Le détecteur de proximité 40 selon le quatrième mode de réalisation de l'invention comporte une tige conductrice 13 de type « pressfit ». La tige conductrice 13 de type « pressfit » présente par exemple une pluralité de lamelles conductrices courbées. Chaque lamelle conductrice courbée comporte une première extrémité et une deuxième extrémité. Les premières extrémités des lamelles conductrices courbées sont rassemblées pour former une première extrémité de la tige conductrice 13. De même, les deuxièmes extrémités des lamelles conductrices courbées sont rassemblées pour former une deuxième extrémité de la tige conductrice 13. La pluralité de lamelles conductrices courbées est agencée autour d'un axe de révolution de la tige conductrice 13, de manière que la tige conductrice 13 présente une partie centrale bombée. La partie centrale bombée est de section supérieure aux première et deuxième extrémités. Selon le quatrième mode de réalisation, la géométrie de type « pressfit » de la tige conductrice 13 assure que la partie centrale bombée de la tige conductrice 13 est en contact avec l'ouverture d'ajustement O du circuit imprimé 2, garantissant ainsi la connexion électrique de l'antenne de détection 1 avec le circuit imprimé 2.

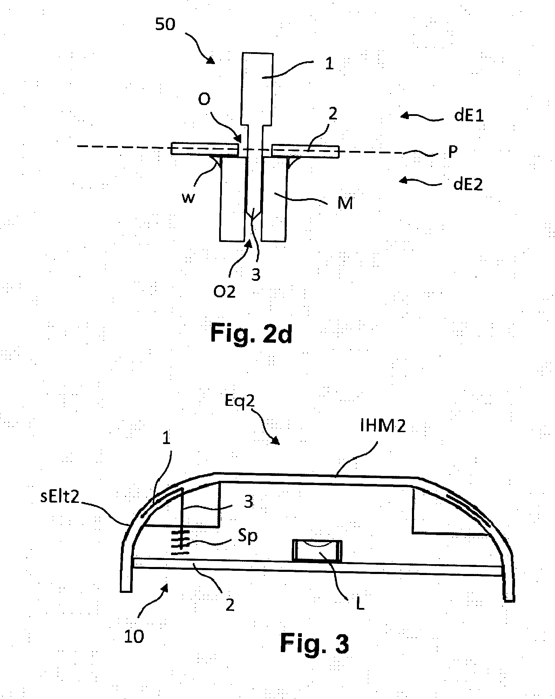

La figure 2d illustre une vue en coupe d'un détecteur de proximité 50 selon un cinquième mode de réalisation de l'invention. Selon le cinquième mode de réalisation de l'invention, le détecteur de proximité 50 comporte un élément de maintien M de la tige conductrice 3. L'élément de maintien M se trouve au contact du circuit imprimé 2, dans le deuxième demi-plan dE2 précédemment défini en lien avec la figure 2b. L'élément de maintien M est conducteur. Un cordon de soudure w rend l'élément de maintien M solidaire du circuit imprimé 2 tout en renforçant la connexion électrique entre l'élément de maintien M et le circuit imprimé 2. L'élément de maintien M présente une ouverture centrale O2. Les dimensions de l'ouverture centrale O2 sont telles que la tige conductrice 3 peut être introduite dans l'ouverture centrale O2 tout en étant en contact avec l'ouverture centrale O2. Autrement dit, l'ouverture centrale O2 se comporte comme une prise femelle pour la tige conductrice 3, et la tige conductrice 3 se comporte comme une prise mâle pour l'ouverture centrale O2. Grâce à l'élément de maintien M, la tige conductrice 3 bénéficie d'un maintien mécanique qui limite les risques de casse de la tige conductrice 3 et/ou de faux-contact entre l'antenne de détection 1 et le circuit imprimé 2.

La figure 3 illustre une vue partielle en coupe d'un deuxième équipement Eq2, le deuxième équipement Eq2 comportant :
- une interface homme-machine IHM2 de type « pommeau » ;
- un élément de surface sElt2 de l'interface homme-machine IHM2 de type « pommeau » ;
- un dispositif d'éclairage L, par exemple une diode LED, permettant le rétroéclairage de l'interface homme-machine IHM2 de type « pommeau ».
La figure 3 montre un autre exemple d'intégration du détecteur de proximité 10 selon le premier mode de réalisation de l'invention, précédemment décrit en lien avec la figure 1a. Un exemple typique de fonctionnement du détecteur de proximité 10 intégré dans le deuxième équipement Eq2 est le suivant :
- un utilisateur, initialement éloigné du deuxième équipement Eq2, approche du deuxième équipement Eq2 et entre dans une zone de fonctionnement du détecteur de proximité 10 ;
- l'antenne de détection 1 du détecteur de proximité 10 génère un signal de détection ;
- le signal de détection est transmis au circuit imprimé 2 grâce à la connexion électrique, assurée dans le cas particulier ici décrit par la tige conductrice 3 et le ressort conducteur Sp, entre l'antenne de détection 1 et le circuit imprimé 2 ;
- le circuit imprimé 2 traite le signal de détection et commande un rétroéclairage de l'interface homme-machine IHM2 de type « pommeau » du deuxième équipement Eq2 par le dispositif d'éclairage L.
Dans le cas particulier ici décrit, le rétroéclairage commandé par le détecteur de proximité 10 permet de rendre le deuxième équipement Eq2 plus facilement repérable par l'utilisateur, en particulier dans un contexte nocturne, et d'améliorer l'ergonomie du deuxième équipement Eq2.

## Revendications

1. Détecteur de proximité (10, 20, 30, 40, 50) d'un équipement (Eq, Eq2) de véhicule automobile comportant :
- une antenne de détection capacitive (1) générant un signal de détection lorsqu'un utilisateur (U) est présent à proximité dudit équipement (Eq, Eq2), l'antenne de détection (1) étant surmoulée dans un élément de surface (sElt) dudit équipement, ledit élément de surface ayant plusieurs côtés, l'antenne de détection (1) s'étendant au moins sur une partie d'un côté de l'élément de surface (sElt), ou sur une partie de deux côtés consécutifs de l'élément de surface (sElt) ;
- un circuit imprimé (2) traitant le signal de détection pour la commande d'une action sur ledit équipement (Eq, Eq2) ;
- une tige conductrice (3, 13) pour la connexion électrique de l'antenne de détection (1) au circuit imprimé (2),
- ladite tige étant un prolongement de l'antenne de détection (1) pour former un ensemble monobloc avec des dernière.

2. Détecteur de proximité (40) selon la revendication précédente **caractérisé en ce que** la tige conductrice (13) est flexible et présente une capacité de rappel.

3. Détecteur de proximité (10, 20, 30, 50) selon la revendication 1 **caractérisé en ce que** la tige conductrice (3) est rigide.

4. Détecteur de proximité (10, 20) selon l'une quelconque des revendications précédentes **caractérisé en ce qu'**il comporte un ressort conducteur (Sp) entourant la tige conductrice (3), le ressort conducteur (Sp) présentant une première extrémité et une deuxième extrémité opposée à la première extrémité, la première extrémité étant au contact de l'antenne de détection (1) et la deuxième extrémité étant au contact du circuit imprimé (2).

5. Détecteur de proximité (10) selon l'une quelconque des revendications précédentes dans lequel la tige conductrice (3) présente une première extrémité et une deuxième extrémité, opposée à la première extrémité, **caractérisé en ce que** la première extrémité de la tige conductrice (3) est en contact avec l'antenne de détection (1) et la deuxième extrémité de la tige conductrice (3) est en contact avec le circuit imprimé (2).

6. Détecteur de proximité (20, 30, 40, 50) selon l'une quelconque des revendications 1 à 4 dans lequel la tige conductrice (3, 13) présente une partie centrale s'étendant entre une première extrémité et une deuxième extrémité, le détecteur de proximité (20, 30, 40, 50) étant **caractérisé en ce que** :
- la première extrémité de la tige conductrice (3, 13) est en contact avec l'antenne de détection (1) ;
- la tige conductrice (3, 13) traverse le circuit imprimé (2) par une ouverture d'ajustement (O) dudit circuit imprimé (2).

7. Détecteur de proximité (50) selon la revendication précédente dans lequel l'antenne de détection (3) est située d'un premier côté (dE1) du circuit imprimé (2), le détecteur de proximité (50) étant **caractérisé en ce qu'**un élément de maintien (M) de la tige conductrice (3) est situé d'un deuxième côté (dE2), opposé au premier côté (dE1), du circuit imprimé (2), l'élément de maintien (M) étant connecté électriquement au circuit imprimé (2).

8. Détecteur de proximité (10, 20, 30, 40, 50) selon l'une quelconque des revendications précédentes **caractérisé en ce que** la tige conductrice (3, 13) est soudée au circuit imprimé (2).

9. Détecteur de proximité (10, 20, 30, 40, 50) selon l'une quelconque des revendications précédentes **caractérisé en ce qu'**il comporte au moins un élément de support mécanique de l'antenne de détection, ledit élément de support mécanique présentant une première extrémité en contact avec l'antenne de détection (1) et une deuxième extrémité, opposée à la première extrémité, en contact avec le circuit imprimé (2).

10. Equipement (Eq, Eq2) de véhicule automobile **caractérisé en ce qu'**il comporte :
- une pluralité d'antennes de détection (10, 20, 30, 40, 50) selon l'une quelconque des revendications 1 à 9, chaque antenne de détection générant un signal de détection lorsqu'un utilisateur est présent à proximité dudit équipement ;
- au moins un circuit imprimé (2) traitant un signal de détection pour la commande d'une action sur ledit équipement ;
- une pluralité de tiges conductrices (3), chaque tige conductrice assurant la connexion électrique entre une desdites antennes de détection (10, 20, 30, 40, 50) et un des circuits imprimés (2).

11. Equipement (Eq, Eq2) de véhicule automobile selon la revendication 10 **caractérisé en ce qu'**il appartient à la liste suivante :
- un écran ;
- un bouton de commande ;
- un système d'éclairage ;
- un levier.

## Patentansprüche

1. Näherungsdetektor (10, 20, 30, 40, 50) einer Kraftfahrzeugausrüstung (Eq, Eq2), aufweisend:
- eine kapazitive Detektionsantenne (1), die ein Detektionssignal erzeugt, wenn ein Benutzer (U) in der Nähe der Ausrüstung (Eq, Eq2) anwesend ist, wobei die Detektionsantenne (1) in einem Oberflächenelement (sElt) der Ausrüstung umformt ist, das Oberflächenelement mehrere Seiten aufweist, die Detektionsantenne (1) sich zumindest auf einem Abschnitt einer Seite des Oberflächenelements (sElt) oder auf einem Abschnitt zweier aufeinanderfolgender Seiten des Oberflächenelements (sElt) erstreckt;
- eine gedruckte Schaltung (2), die das Detektionssignal zur Steuerung einer Aktion auf der Ausrüstung (Eq, Eq2) verarbeitet;
- einen leitenden Stab (3, 13) zur elektrischen Verbindung der Detektionsantenne (1) mit der gedruckten Schaltung (2),
- wobei der Stab eine Verlängerung der Detektionsantenne (1) ist, um eine einstückige Anordnung mit letzteren zu bilden.

2. Näherungsdetektor (40) nach dem vorhergehenden Anspruch, **dadurch gekennzeichnet, dass** der leitende Stab (13) flexibel ist und ein Rückstellvermögen aufweist.

3. Näherungsdetektor (10, 20, 30, 50) nach Anspruch 1, **dadurch gekennzeichnet, dass** der leitende Stab (3) starr ist.

4. Näherungsdetektor (10, 20) nach einem der vorhergehenden Ansprüche, **dadurch gekennzeichnet, dass** er eine leitende Feder (Sp) aufweist, die den leitenden Stab (3) umgibt, wobei die leitende Feder (Sp) ein erstes Ende und ein zweites Ende, das dem ersten Ende gegenüberliegt, aufweist, wobei das erste Ende mit der Detektionsantenne (1) und das zweite Ende mit der gedruckten Schaltung (2) in Kontakt steht.

5. Näherungsdetektor (10) nach einem der vorhergehenden Ansprüche, wobei der leitende Stab (3) ein erstes Ende und ein zweites Ende, das dem ersten Ende gegenüberliegt, aufweist, **dadurch gekennzeichnet, dass** das erste Ende des leitenden Stabs (3) mit der Detektionsantenne (1) und das zweite Ende des leitenden Stabs (3) mit der gedruckten Schaltung (2) in Kontakt steht.

6. Näherungsdetektor (20, 30, 40, 50) nach einem der Ansprüche 1 bis 4, wobei der leitende Stab (3, 13) einen mittleren Abschnitt aufweist, der sich zwischen einem ersten Ende und einem zweiten Ende erstreckt, wobei der Näherungsdetektor (20, 30, 40, 50) **dadurch gekennzeichnet ist, dass**:
- das erste Ende des leitenden Stabs (3, 13) mit der Detektionsantenne (1) in Kontakt steht;
- der leitende Stab (3, 13) durch eine Einstellöffnung (O) der gedruckten Schaltung (2) durch die gedruckte Schaltung (2) hindurchgeht.

7. Näherungsdetektor (50) nach dem vorhergehenden Anspruch, wobei sich die Detektionsantenne (3) auf einer ersten Seite (dE1) der gedruckten Schaltung (2) befindet, wobei der Näherungsdetektor (50) **dadurch gekennzeichnet ist, dass** sich ein Halteelement (M) des leitenden Stabs (3) auf einer zweiten Seite (dE2) befindet, die der ersten Seite (dE1) der gedruckten Schaltung (2) gegenüberliegt, wobei das Halteelement (M) mit der gedruckten Schaltung (2) elektrisch verbunden ist.

8. Näherungsdetektor (10, 20, 30, 40, 50) nach einem der vorhergehenden Ansprüche, **dadurch gekennzeichnet, dass** der leitende Stab (3, 13) an die gedruckte Schaltung (2) gelötet ist.

9. Näherungsdetektor (10, 20, 30, 40, 50) nach einem der vorhergehenden Ansprüche, **dadurch gekennzeichnet, dass** er mindestens ein mechanisches Tragelement der Detektionsantenne umfasst, wobei das mechanische Tragelement ein erstes Ende in Kontakt mit der Detektionsantenne (1) und ein zweites Ende, das dem ersten Ende gegenüberliegt, in Kontakt mit der gedruckten Schaltung (2) aufweist.

10. Kraftfahrzeugausrüstung (Eq, Eq2), **dadurch gekennzeichnet, dass** sie Folgendes aufweist:
- eine Mehrzahl von Detektionsantennen (10, 20, 30, 40, 50) nach einem der Ansprüche 1 bis 9, wobei jede Detektionsantenne ein Detektionssignal erzeugt, wenn ein Benutzer in der Nähe der Ausrüstung anwesend ist;
- mindestens eine gedruckte Schaltung (2), die ein Detektionssignal zur Steuerung einer Aktion auf der Ausrüstung verarbeitet;
- eine Mehrzahl von leitenden Stäben (3), wobei jeder leitende Stab die elektrische Verbindung zwischen einer der Detektionsantennen (10, 20, 30, 40, 50) und einer der gedruckten Schaltungen (2) sicherstellt.

11. Kraftfahrzeugausrüstung (Eq, Eq2) nach Anspruch 10, **dadurch gekennzeichnet, dass** sie zur folgenden Liste gehört:
- ein Bildschirm;
- ein Steuerknopf;
- ein Beleuchtungssystem;
- ein Hebel.

## Claims

1. Proximity detector (10, 20, 30, 40, 50) for a device (Eq, Eq2) for an automotive vehicle, comprising:
- a capacitive detection antenna (1) that generates a detection signal when a user (U) is present in the proximity of said device (Eq, Eq2), the detection antenna (1) being overmoulded in a surface element (sElt) of said device, said surface element having a plurality of sides, the detection antenna (1) extending at least over a portion of one side of the surface element (sElt), or over a portion of two consecutive sides of the surface element (sElt);
- a printed circuit board (2) that processes the detection signal for controlling an action on said device (Eq, Eq2);
- a conductive rod (3, 13) for electrically connecting the detection antenna (1) to the printed circuit board (2),
- said rod being an extension of the detection antenna (1) so as to form a one-piece assembly with the latter.

2. Proximity detector (40) according to the preceding claim, **characterized in that** the conductive rod (13) is flexible and has a memory capacity.

3. Proximity detector (10, 20, 30, 50) according to Claim 1, **characterized in that** the conductive rod (3) is rigid.

4. Proximity detector (10, 20) according to any one of the preceding claims, **characterized in that** it comprises a conductive spring (Sp) surrounding the conductive rod (3), the conductive spring (Sp) having a first end and a second end that is opposite the first end, the first end being in contact with the detection antenna (1) and the second end being in contact with the printed circuit board (2).

5. Proximity detector (10) according to any one of the preceding claims, in which the conductive rod (3) has a first end and a second end, opposite the first end, **characterized in that** the first end of the conductive rod (3) is in contact with the detection antenna (1) and the second end of the conductive rod (3) is in contact with the printed circuit board (2) .

6. Proximity detector (20, 30, 40, 50) according to any one of Claims 1 to 4, in which the conductive rod (3, 13) has a central portion that extends between a first end and a second end, the proximity detector (20, 30, 40, 50) being **characterized in that**:
- the first end of the conductive rod (3, 13) is in contact with the detection antenna (1);
- the conductive rod (3, 13) passes through the printed circuit board (2) via an adjustment opening (O) in said printed circuit board (2).

7. Proximity detector (50) according to the preceding claim, in which the detection antenna (3) is located on a first side (dE1) of the printed circuit board (2), the proximity detector (50) being **characterized in that** an element (M) for retaining the conductive rod (3) is located on a second side (dE2), opposite the first side (dE1), of the printed circuit board (2), the retaining element (M) being electrically connected to the printed circuit board (2).

8. Proximity detector (10, 20, 30, 40, 50) according to any one of the preceding claims, **characterized in that** the conductive rod (3, 13) is soldered to the printed circuit board (2).

9. Proximity detector (10, 20, 30, 40, 50) according to any one of the preceding claims, **characterized in that** it comprises at least one element for mechanically supporting the detection antenna, said mechanical support element having a first end that is in contact with the detection antenna (1) and a second end, opposite the first end, that is in contact with the printed circuit board (2).

10. Device (Eq, Eq2) for an automotive vehicle, **characterized in that** it comprises:
- a plurality of detection antennas (10, 20, 30, 40, 50) according to any one of Claims 1 to 9, each detection antenna generating a detection signal when a user is present in the proximity of said device;
- at least one printed circuit board (2) that processes a detection signal for controlling an action on said device;
- a plurality of conductive rods (3), each conductive rod ensuring the electrical connection between one of said detection antennas (10, 20, 30, 40, 50) and one of the printed circuit boards (2) .

11. Device (Eq, Eq2) for an automotive vehicle according to Claim 10, **characterized in that** it belongs to the following list:
- a screen;
- a control button;
- a lighting system;
- a lever.
